# EUROPEAN PATENT APPLICATION

(11) **EP 2 226 837 A1**
(43) Date of publication of application: **08.09.2010**
(21) Application number: 08865395.1
(22) Date of filing: 24.12.2008
(51) Int. Cl.: H01L 21/60

(54) **DEVICE FOR ELIMINATING SLACKNESS OF SHOCK-ABSORBING TAPE**

(30) Priority: 25.12.2007 JP 2007331698
(71) Applicant: Ohashi Engineering Co., Ltd, Ota-ku Tokyo 143-0013 (JP)
(72) Inventor: SUZUKI, Shinji, Tokyo 143-0013 (JP)
(74) Representative: Haley, Stephen
(86) International application number: PCT/JP2008/073386
(87) International publication number: WO 2009/081924

(57) **Abstract**

Disclosed is a device for eliminating slackness of a shock-absorbing tape, which can be reduced in size. A source side of a shock-absorbing tape (80) is wound on a let-off shaft (6), and a target side of the shock-absorbing tape (80) is taken up by a take-up shaft (7). In order to adhere an ACF to an electric work or to pressure bond an electric part to the electric work via the ACF, a head member moves forward to the electric work while pushing the shock-absorbing tape (80) and then moves backward, thereby causing slackness of the shock-absorbing tape (80). The take-up shaft (7) is connected to a drive shaft (16) by a connecting means (24), and friction members (31, 33) are disposed between the drive shaft (16) and the let-off shaft (6). Rotation of the drive shaft (16) is transmitted to the take-up shaft (7) via the connecting means (24) and to the let-off shaft (6) via the friction members (31, 33), thereby eliminating the aforementioned slackness by the take-up shaft (7) and the let-off shaft (6) rotating in opposite directions from each other.

## Description

### Technical Field

The present invention relates to a device for eliminating slackness of a shock-absorbing tape used for adhering an ACF (Anisotropic Conductive Film) to an electric work including an electronic work, or for pressure bonding an electric part including an electronic part to the electric work via the ACF, and can be used, for example, for an operation to adhere the ACF to an electric work such as an LCD (Liquid Crystal Display), a PCB (Printed Circuits Board), an FPC (Flexible Printed Circuit), or the like, or for an operation to pressure bond an electric part such as an IC (Integrated Circuit) chip, an FPC, or the like for example to the electric work via the ACF.

### Background Art

For attaching an IC chip as an electric part for an LCD and as a driver chip for this LCD to the LCD as an electric work, there are performed an operation to adhere an ACF to the LCD (first process), an operation to temporarily pressure bond the IC chip to this ACF (second process), and an operation to permanently pressure bond the IC chip to the LCD via the ACF (third process). The operations of these processes are performed using head members of respective processes which are movable toward the LCD. Each head member moves forward to the LCD to thereby perform one of adhering the ACF to the LCD, temporarily pressure bonding the IC chip to the ACF, and permanently pressure bonding the IC chip to the LCD via the ACF.

Further, the first process is performed by disposing a shock-absorbing member for evenly adhering the ACF to the LCD between the head member and the ACF and LCD. This shock-absorbing member moves toward the ACF and LCD side while being pushed by the head member, and pressure force of the head member operates on the ACF via the shock-absorbing member, thereby adhering the ACF to the LCD evenly by the operation of the shock-absorbing member. Further, in the third process, a shock-absorbing member for permanently pressure bonding the IC chip to the LCD evenly via the ACF is disposed between the head member and the IC chip, ACF, and LCD. This shock-absorbing member moves toward the IC chip, ACF and LCD side while being pushed by the head member, and pressure force of the head member operates on the IC chip and ACF via the shock-absorbing member, thereby permanently pressure bonding the IC chip to the LCD evenly via the ACF by the operation of the shock-absorbing member.

Incidentally, the ACF has an adhesive component, and thus the shock-absorbing members in the first and third processes are used also for preventing the adhesive component of the ACF from adhering to the respective head members used in these processes.

In a device described in Patent Document 1 below, a tape is adopted as the above-described shock-absorbing member. Accordingly, this device described in Patent Document 1 has a let-off shaft on which a source side portion of the shock-absorbing tape is wound, and a take-up shaft for taking up a target side portion of the shock-absorbing tape.

In the first and third processes, after the head member moves forward to push the shock-absorbing tape to the LCD side, the head member moves backward to the original position. This forward/backward movement of the head member causes slackness of the shock-absorbing tape. This slackness of the shock-absorbing tape must be eliminated until the head member moves forward next time.

The device for eliminating slackness of the shock-absorbing tape disclosed in above-described Patent Document 1 has a swing member for swinging one of plural guide rollers for the shock-absorbing tape which are disposed between the above-described let-off shaft and the above-described take-up shaft. Slackness of the shock-absorbing tape is eliminated by swinging this swing member.
Patent Document 1: Japanese Patent Application Laid-open No. 2006-210464

### Disclosure of Invention

### Problem to be Solved by the Invention

This slackness eliminating device for a shock-absorbing tape using the swing member requires a swingable swing member, and has a problem that it is difficult to reduce the size of the device because a space for swinging this swing member is needed.

An object of the present invention is to provide a device for eliminating slackness of a shock-absorbing tape which enables to reduce the size of the device.

### Means for Solving the Problem

A device for eliminating slackness of a shock-absorbing tape according to the present invention includes a shock-absorbing tape disposed between an electric work and a head member movable toward the electric work, so as to adhere an ACF to the electric work to which an electric part is pressure bonded via the ACF, or to pressure bond the electric part to the electric work via the ACF, and the device includes a let-off shaft on which a source side portion of the shock-absorbing tape is wound, in which slackness is generated by the head member moving forward to the electric work while pushing the shock-absorbing tape and then moving backward, and a take-up shaft for taking up a target side portion of the shock-absorbing tape. The device includes a drive shaft connected to the take-up shaft via a connecting means for rotating the take-up shaft in a direction to take up the shock-absorbing tape, and at least one friction member disposed between the drive shaft and the let-off shaft, in which a rotational direction of the take-up shaft for the take-up shaft to take up the shock-absorbing tape and a rotational direction of the drive shaft for the take-up shaft to take up the shock-absorbing tape are the same, and a rotational direction for the let-off shaft to let off the shock-absorbing tape and the rotational direction for the take-up shaft to take up the shock-absorbing tape are opposite.

In this device for eliminating slackness of the shock-absorbing tape, when the drive shaft and the take-up shaft are stationary, the head member moves forward to push the shock-absorbing tape toward the electric work side. This forward movement of the head member causes tensile force to operate on the shock-absorbing tape, and thus the source side portion of the shock-absorbing tape wound on the let-off shaft is let off from the let-off shaft. This letting off is performed by rotation of the let-off shaft relative to the drive shaft which is stationary, and the rotation of the let-off shaft relative to the drive shaft is allowed by a slip generated between the let-off shaft and the drive shaft by the friction member. Thereafter, the head member moves back to the original position.

This forward and backward movement of the head member causes slackness on the shock-absorbing tape corresponding to the length of the shock-absorbing tape let off from the let-off shaft. After the slackness thus occurred on the shock-absorbing tape, rotation of the drive shaft causes the take-up shaft to rotate in a direction to take up the shock-absorbing tape. At this time, no tensile force has occurred on the shock-absorbing tape due to the slackness, and rotational force of the drive shaft operates on the let-off shaft by friction force of the friction member. Thus, the let-off shaft rotates in a direction opposite to a direction to let-off the shock-absorbing tape, that is, the direction to take up the shock-absorbing tape.

Accordingly, the shock-absorbing tape is taken up by both the take-up shaft and the let-off shaft, and the slackness of the shock-absorbing tape is eliminated by taking up by both the take-up shaft and the let-off shaft.

In the device according to the present invention, slackness of the shock-absorbing tape is thus eliminated by taking up the shock-absorbing tape by the take-up shaft and the let-off shaft, and this elimination is performed without using a swingable swing member. Thus, it is not necessary to secure a space for the swing member to swing in the device according to the present invention. Therefore, reduction in size of the device can be achieved.

Further, with the device according to the present invention, as a drive source for eliminating slackness of the shock-absorbing tape, only a drive source for rotating the drive shaft will suffice, and thus simplification of the structure of the device can be achieved.

Further, in the device according to the present invention, slackness of the shock-absorbing tape is eliminated by taking up the shock-absorbing tape by both the take-up shaft and the let-off shaft, and moreover, the take-up shaft and the let-off shaft are rotated simultaneously by rotation of the drive shaft. Thus, elimination of slackness of the shock-absorbing tape is carried out quickly and hence in a short time. Accordingly, the number of times of operations performed by one time of forward and backward movement of the head member can be increased within a certain time, and thus operation efficiency can be improved.

Further, in the device according to the present invention, the shock-absorbing tape is taken up on the take-up shaft by rotation of the take-up shaft in the direction to take up the shock-absorbing tape by rotation of the drive shaft. At this time, the let-off shaft is rotated in the direction to let off the shock-absorbing tape by tensile force of the shock-absorbing tape. When the let-off shaft thus rotates in the direction to let off the shock-absorbing tape, and the rotational direction of the let-off shaft for letting off and the rotational direction of the drive shaft to take up the shock-absorbing tape on the take-up shaft are opposite, a slip by the friction member occurs between the drive shaft and the let-off shaft, thereby allowing the let-off shaft to rotate in the direction to let off the shock-absorbing tape toward the drive shaft.

In the present invention, for the above-described connecting means connecting the drive shaft and the take-up shaft, any connecting means can be adopted as long as it transmits rotation of the drive shaft to the take-up shaft, in which the rotational direction of the drive shaft and the rotational direction of the take-up shaft are the same. This connecting means may be means using an endless traveling member such as a belt or chain, and may be one having a gear train with a plurality of gears arranged.

Further, in the present invention, the positional relation between the drive shaft and the let-off shaft may be set arbitrarily. An example of this positional relation is such that the let-off shaft is made as a hollow member, and the drive shaft is inserted in this hollow let-off shaft.

Accordingly, the inside space of the let-off shaft is used as a space for disposing the drive shaft, and thus reduction in size of the device can be achieved more effectively.

Further, for rotating the drive shaft and transmitting rotation of this drive shaft to the take-up shaft when the drive shaft is inserted in the let-off shaft thus being a hollow member, both end portions of the drive shaft may project from the let-off shaft, and a drive gear meshing with a transmission gear for rotating the drive shaft may be fixed to one of the end portions, and the other one of the end portions may be connected to the take-up shaft via the connecting means.

Further, when the drive shaft is inserted in the let-off shaft being a hollow member as described above, the friction member may be in a plate shape whose thickness direction is in an axial direction of the drive shaft, or the friction member may be in a cylindrical shape engaged with an outer periphery of the drive shaft.

Furthermore, there may be a plurality of the friction members. When there is such a plurality of the friction members, these friction members may be disposed in an axial direction of the drive shaft.

Further, the device according to the present invention may be provided with a braking means for applying braking force to the let-off shaft when the let-off shaft lets off the shock-absorbing tape.

Accordingly, when the let-off shaft is rotated in a direction to let off the shock-absorbing tape by forward movement of the head member and/or rotation of the drive shaft, the rotation of the let-off shaft can be braked by the braking means, and thus it is possible to prevent the shock-absorbing tape from being let off excessively from the let-off shaft.

The braking means can be formed of an arbitrary structure, and an example thereof is such that the braking means includes a brake member contacting an outer peripheral face of the let-off shaft.

When the braking means thus includes a brake member contacting an outer peripheral face of the let-off shaft, the outer peripheral face of the let-off shaft where the brake member contacts is preferably an outer peripheral face of a flange part of the let-off shaft which is formed larger in diameter than a body of the let-off shaft. This enables to obtain a large brake torque.

Furthermore, the mode of motion of the brake member for contacting the outer peripheral face of the let-off shaft is arbitrary, and an example thereof is such that the brake member is a member which pivots about a bar, and the brake member is made to contact the outer peripheral face of the let-off shaft by this pivoting. This enables to simplify the shape and structure of the brake member itself, thereby allowing to produce the braking means easily.

The shock-absorbing tape in the device according to the present invention may be one used for operation to attach the ACF to the electric work, or one used for operation to pressure bond the electric part to the electric work via the ACF.

The electric work includes an electronic work, and the electric part also includes an electronic part. The electric work is, for example, an LCD, a PCB, an FPC, or the like, and the electric part is, for example, an IC chip, an FPC, or the like.

### Effects of the Invention

According to the present invention, it is possible to obtain advantages such that a device can be reduced in size and that elimination of slackness of a shock-absorbing tape can be performed quickly and hence in a short time.

### Brief Description of Drawings

FIG. 1 is a side view of a shock-absorbing tape supply device of cassette type having a device for eliminating slackness of a shock-absorbing tape according to an embodiment of the present invention as a part;
FIG. 2 is a plan view of the shock-absorbing tape supply device shown in FIG. 1;
FIG. 3 is a partially enlarged view of FIG. 2 and shows a cross section of a let-off shaft;
FIG. 4 is a side view showing that the shock-absorbing tape supply device shown in FIG. 1 is set to an ACF adhering apparatus;
FIG. 5 is a side view showing that a brake driving device for operating a brake member provided in the shock-absorbing tape supply device shown in FIG. 1 is attached to the ACF adhering apparatus;
FIG. 6 is a view similar to FIG. 4 when an operation to adhere an ACF to an electric work is performed using a shock-absorbing tape of the shock-absorbing tape supply device shown in FIG. 1; and
FIG 7 is a view similar to FIG. 3 showing a shock-absorbing tape supply device according to another embodiment with respect to friction members.

Explanation of Numerals and Symbols
- 1: shock-absorbing tape supply device of cassette type
- 2: connecting bar
- 6, 40: let-off shaft
- 7: take-up shaft
- 16, 41: drive shaft
- 20: drive gear
- 24: connecting means
- 31, 33: plate-shaped friction member
- 34: brake member
- 35: braking means
- 42, 43: cylindrical friction member
- 80: shock-absorbing tape
- 85: electric work
- 86: ACF tape
- 86A: ACF
- 90: ACF adhering apparatus
- 95: transmission gear
- 97: brake driving device
- 98: head member

### Best Mode for Carrying Out the Invention

Hereinafter, an embodiment for carrying out the present invention will be described based on the drawings. A device for eliminating slackness of a shock-absorbing tape according to this embodiment is a part of a shock-absorbing tape supply device set to an ACF adhering apparatus used for adhering an ACF to an electric work, and this shock-absorbing tape supply device is of cassette type detachably set to the ACF adhering apparatus.

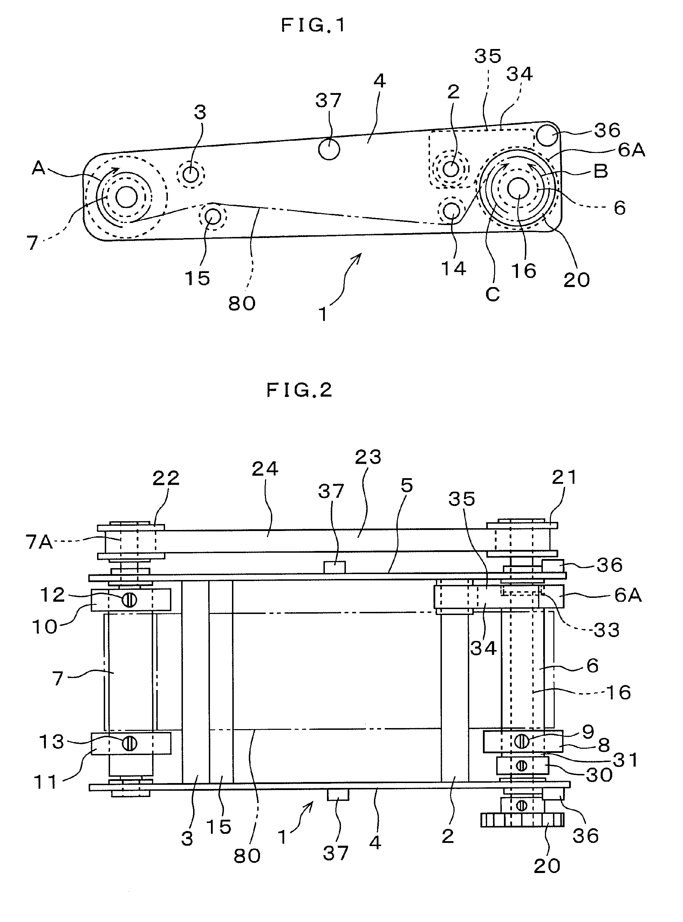

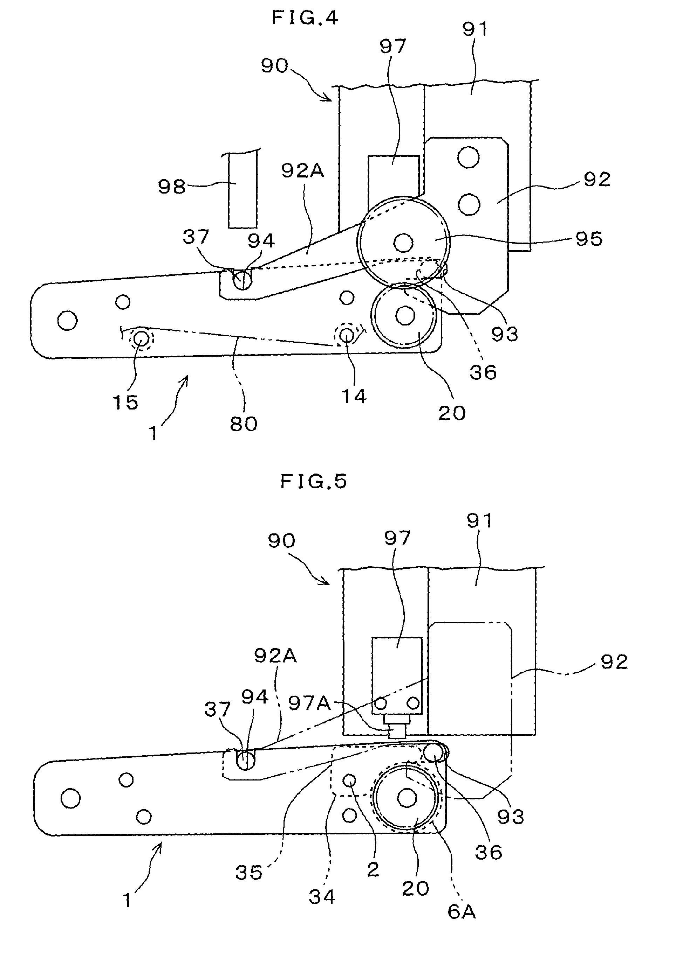

FIG. 1 is a side view of this shock-absorbing tape supply device 1 of cassette type, and FIG. 2 is a plan view of the shock-absorbing tape supply device 1. FIG. 4 to FIG. 6 show an ACF adhering apparatus 90.

As shown in FIG. 1 and FIG. 2, the body of the shock-absorbing tape supply device 1 is formed of two plate members 4, 5 connected in parallel by connecting bars 2, 3. A let-off shaft 6 for letting off a shock-absorbing tape 80 is disposed rotatably between one end portions of the plate members 4, 5, and a take-up shaft 7 for taking up the shock-absorbing tape 80 is provided rotatably across the other end portions of the plate members 4, 5. A source side portion of the shock-absorbing tape 80 is wound on the let-off shaft 6, and this source side portion is connected to the let-off shaft 6 by a connecting member such as an adhesive tape. A target side portion of the shock-absorbing tape 80 is connected to the take-up shaft 7 by a connecting member such as an adhesive tape. The shock-absorbing tape 80 is made as a tape of, for example, a shock-absorbing material formed of an elastic material such as urethane rubber.

As shown in FIG. 2, on the let-off shaft 6, a flange part 6A having a diameter larger than the body of the let-off shaft 6 is formed on one portion in an axial direction length of this let-off shaft 6, and a flange member 8 is disposed at a position separated in the axial direction from the flange part 6A on an outer periphery of the let-off shaft 6. This flange member 8 is fixed to the let-off shaft 6 by a screw 9 which reaches the let-off shaft 6, and by loosening this screw 9, the flange member 8 can be moved to the position corresponding to a width dimension of the shock-absorbing tape 80 wound on the let-off shaft 6 between the flange part 6A and the flange member 8. Accordingly, respective shock-absorbing tapes having different width dimensions can be disposed between the flange part 6A and the flange member 8.

Further, on an outer periphery of the take-up shaft 7, two flange members 10, 11 are disposed at positions separated from each other in an axial direction on the take-up shaft 7, and these flange members 10, 11 are fixed to the take-up shaft 7 by screws 12, 13 which reach the take-up shaft 7. By loosening the screws 12, 13, the arranged positions of the flange members 10, 11 in the axial direction of the take-up shaft 7 can be changed. Thus, the flange member 10 can be arranged precisely in an axial direction position of the take-up shaft 7 that corresponds to the flange part 6A of the let-off shaft 6 by loosening the screw 12, and the flange member 11 can be arranged precisely in an axial direction position of the take-up shaft 7 that corresponds to the flange member 8 of the let-off shaft 6 by loosening the screw 13.

Two guide rollers 14, 15 are provided rotatably across the two plate members 4, 5 forming the body of the shock-absorbing tape supply device 1, and the shock-absorbing tape 80 travels from the let-off shaft 6 side to the take-up shaft 7 side while being guided by the guide rollers 14, 15 disposed between the let-off shaft 6 and the take-up shaft 7.

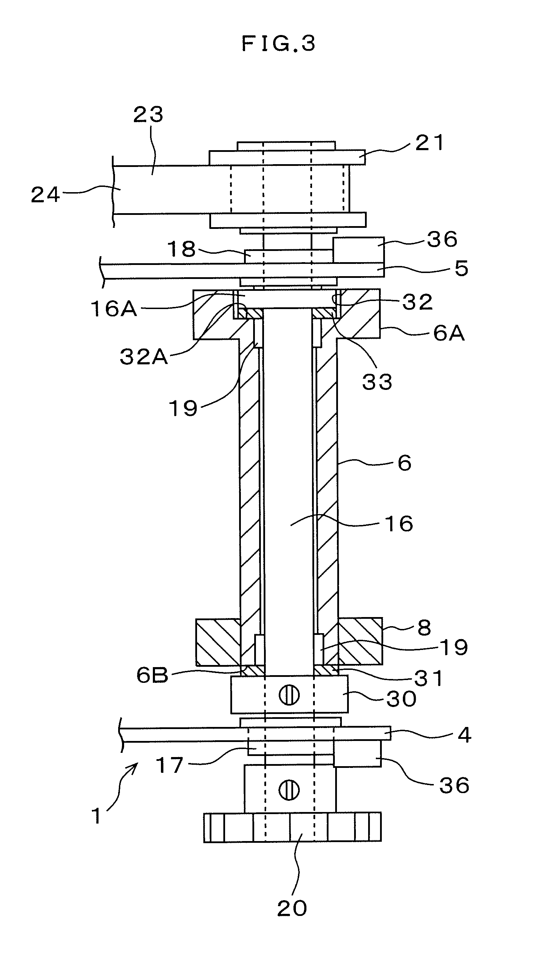

FIG. 3 is a partially enlarged view of FIG. 2 and shows a cross section of the let-off shaft 6. As shown in FIG. 3, the let-off shaft 6 is a hollow member, and a drive shaft 16 is inserted in this hollow let-off shaft 6. The drive shaft 16 has a length to penetrate through the plate members 4, 5, and is supported rotatably on the plate members 4, 5 by bearing members 17, 18. Further, the let-off shaft 6 is supported rotatably on the drive shaft 16 by a bearing member 19. Both end portions of the drive shaft 16 project from the let-off shaft 6, and a drive gear 20 is fixed to one end portion of these end portions that projects toward the outside of the plate member 4. A timing pulley 21 is attached to the other end portion projecting toward the outside of the plate member 5. Further, as shown in FIG. 2, one end portion 7A of the take-up shaft 7 projects toward the outside of the plate member 5, and a timing pulley 22 is attached to this end portion 7A.

A timing belt 23 as an endless traveling member is provided across both the timing pulleys 21, 22. Thus, the timing pulleys 21, 22 and the timing belt 23 constitute a connecting means 24 for connecting the other end portion of the drive shaft 16 and the take-up shaft 7. This connecting means 24 transmits rotation of the drive shaft 16 to the take-up shaft 7, and causes the take-up shaft 7 to rotate in the same direction as a rotational direction of the drive shaft 16.

As shown in FIG. 3, a flange member 30 is attached at a position between the two plate members 4, 5, the position being on an outer periphery of the drive shaft 16 that is outside the let-off shaft 6. A first plate-shaped friction member 31 whose thickness direction is in the axial direction of the drive shaft 16 is interposed between the flange member 30 and an end face 6B of the let-off shaft 6, and this friction member 31 is in a ring shape disposed on the outer periphery of the drive shaft 16.

Further, a depressed portion 32 is formed inside the above-described flange part 6A of the let-off shaft 6, and a flange part 16A inserted in this depressed portion 32 is formed in the drive shaft 16. A second plate-shaped friction member 33 whose thickness direction is in the axial direction of the drive shaft 16 is interposed between a bottom face 32A of the depressed portion 32 and the flange part 16A, and this friction member 33 is also in a ring shape disposed on the outer periphery of the drive shaft 16.

Accordingly, in this embodiment, the two plate-shaped friction members 31, 33 are disposed in the axial direction of the drive shaft 16. These friction members 31, 33 are formed by stacking and connecting a synthetic resin plate formed of polyacetal or the like having self-lubricity onto an elastic base plate formed of a wave washer or the like, for example. In the first plate-shaped friction member 31, the synthetic resin plate is pressed against the end face 6B of the let-off shaft 6 by the elastic force of the elastic base plate receiving pressure force from the flange member 30. In the second plate-shaped friction member 33, the synthetic resin plate is pressed against the bottom face 32A of the depressed portion 32 by the elastic force of the elastic base plate receiving pressure force from the flange part 16A.

In the above structure, a rotational direction in which the take-up shaft 7 takes up the shock-absorbing tape 80 is A direction shown in FIG. 1. Further, a rotational direction in which the let-off shaft 6 lets off the shock-absorbing tape 80 is B direction opposite to the A direction. Furthermore, rotation of the drive shaft 16 is transmitted to the take-up shaft 7 via the connecting means 24, and since the connecting means 24 is made up of the pulleys 21, 22 and the belt 23, a rotational direction of the drive shaft 16 when the take-up shaft 7 takes up the shock-absorbing tape 80 is C direction which is the same direction as the A direction.

As shown in FIG. 2, a brake member 34 facing an upper face of the flange part 6A of the let-off shaft 6 is disposed between the two plate members 4, 5, and this brake member 34 is vertically pivotable about the connecting bar 2 out of the above-described connecting bars 2, 3 as can be seen in FIG. 1. The brake member 34 constitutes a braking means 35 for giving braking force to the let-off shaft 6 when the shock-absorbing tape 80 is let off from the let-off shaft 6, as can be seen from the description below.

Further, first and second pin members 36, 37 are attached to outer faces of the plate members 4, 5. These pin members 36, 37 separated in a feeding direction of the shock-absorbing tape 80 are used when setting the cassette type shock-absorbing tape supply device 1 to the ACF adhering apparatus 90 shown in FIG. 4 to FIG. 6. Specifically, brackets 92 each having an arm portion 92A are attached to a body 91 of this apparatus 90 and extend forward from the body 91. In each bracket 92, a first recess 93 opening forward is formed in a base portion of the arm portion 92A, and a second recess 94 opening upward is formed in a front end of the arm portion 92A. There are two such brackets 92 provided on the body 91 and separated by a distance corresponding to the distance between the two plate members 4, 5. The first pin member 36 is engaged with the first recesses 93, the second pin member 37 is engaged with the second recesses 94, and thereby the shock-absorbing tape supply device 1 can be set horizontally to the body 91 of the apparatus 90 via the brackets 92. Further, by allowing the pin members 36, 37 to be released from the recesses 93, 94, the shock-absorbing tape supply device 1 can be disengaged from the body 91 of the apparatus 90. Thus the shock-absorbing tape supply device 1 is engageable with/disengageable from the ACF adhering apparatus 90.

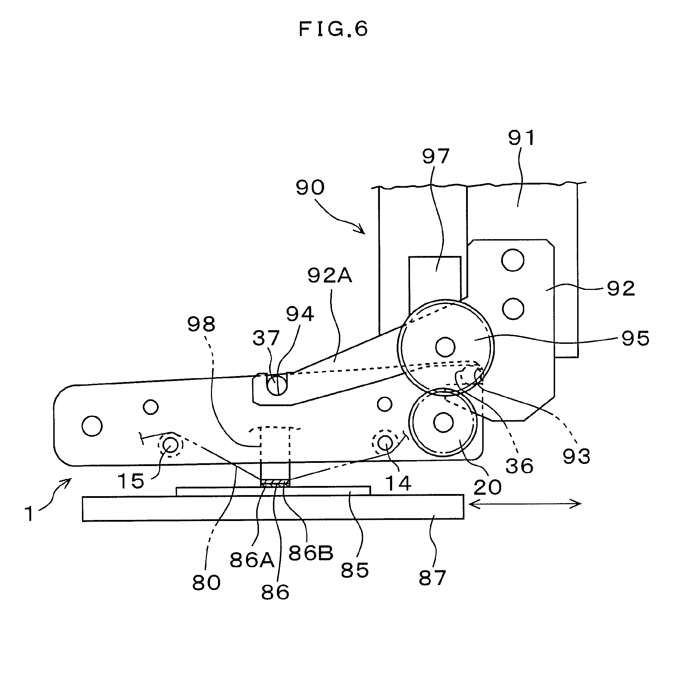

The shock-absorbing tape supply device 1 is prepared in a plurality. As shown in FIG. 6, one shock-absorbing tape supply device 1 is set to the ACF adhering apparatus 90. While an operation to attach an ACF 86A of an ACF tape 86 to an electric work 85 is performed using the shock-absorbing tape 80 of this device 1, a source side portion of another shock-absorbing tape 80 is connected to the let-off shaft 6 of another shock-absorbing tape supply device 1, and there are performed an operation to take up the source side portion of this shock-absorbing tape 80 on the let-off shaft 6 of the aforementioned another shock-absorbing tape supply device 1 and an operation to connect a target side portion of this shock-absorbing tape 80 to the take-up shaft 7 of the aforementioned another shock-absorbing tape supply device 1.

Accordingly, when substantially all of the shock-absorbing tape 80 of the shock-absorbing tape supply device 1 set to the ACF adhering apparatus 90 is taken up on the take-up shaft 7, and the shock-absorbing tape supply device 1 needs to be replaced, a new shock-absorbing tape supply device 1 can be replaced and set immediately to the ACF adhering apparatus 90.

Further, when the shock-absorbing tape supply device 1 is set to the ACF adhering apparatus 90, a transmission gear 95 provided in the ACF adhering apparatus 90 engages with the above-described drive gear 20 provided in this shock-absorbing tape supply device 1, as shown in FIG. 4. This transmission gear 95 is rotated by an electric motor provided in the ACF adhering apparatus 90, causing the drive gear 20 and the drive shaft 16 of the shock-absorbing tape supply device 1 to rotate.

As shown in FIG. 5, a brake driving device 97 is also provided in the body 91 of the ACF adhering apparatus 90. This brake driving device 97 is attached to the body 91 of the ACF adhering apparatus 90 between the above-described two brackets 92. The brake driving device 97 is located right above the above-described brake member 34 of the shock-absorbing tape supply device 1 when the shock-absorbing tape supply device 1 is set to the ACF adhering apparatus 90. The brake driving device 97 is formed of a cylinder or a solenoid, and has a rod member 97A which moves up and down.

Moreover, as shown in FIG. 4, the ACF adhering apparatus 90 is provided with a head member 98. This head member 98 is located right above the shock-absorbing tape 80 between the let-off shaft 6 and the take-up shaft 7 of the shock-absorbing tape supply device 1 when the shock-absorbing tape supply device 1 is set to the ACF adhering apparatus 90. Further, this head member 98 moves forward and backward relative to the shock-absorbing tape supply device 1, in other words, it moves up and down.

Next, an operation performed for attaching the ACF 86A of the ACF tape 86 to the electric work 85 using the shock-absorbing tape 80 of the shock-absorbing tape supply device 1 set to the ACF adhering apparatus 90 will be described.

The shock-absorbing tape 80 between the let-off shaft 6 and the take-up shaft 7 before starting this operation is not loose and is in a tense state. Further, the electric work 85 positioned and set to an upper face of a slide table 87 shown in FIG. 6 is fed to a lower side of the shock-absorbing tape supply device 1 by slide movement of the slide table 87. Furthermore, the ACF tape 86 in an ACF supply device set to the ACF adhering apparatus 90 is arranged between the shock-absorbing tape supply device 1 and the electric work 85. This ACF tape 86 is such that the ACF 86A adheres to the entire lower face of a separate film 86B. Further, the feeding direction of the ACF tape 86 in the ACF supply device is an orthogonal direction to the feeding direction of the shock-absorbing tape 80 in the shock-absorbing tape supply device 1. Accordingly, the ACF tape 86 is fed in a direction orthogonal to the view of FIG. 6.

When the transmission gear 95 of the ACF adhering apparatus 90 is stationary, in other words, when the drive gear 20, the drive shaft 16, and the take-up shaft 7 of the shock-absorbing tape supply device 1 are stationary, the head member 98 moves down to push the shock-absorbing tape 80 toward the electric work 85 side, as shown in FIG. 6. This downward movement causes tensile force to operate on the shock-absorbing tape 80 pushed by the head member 98, and thus the source side portion of the shock-absorbing tape 80 wound on the let-off shaft 6 is let off from the let-off shaft 6. This letting off is performed by rotation of the let-off shaft 6 in the B direction relative to the drive shaft 16 which is stationary, and the rotation of the let-off shaft 6 in the B direction is allowed by a slip generated between the let-off shaft 6 and the drive shaft 16 by the first and second plate-shaped friction members 31, 33.

As described above, by the head member 98 moving down while the shock-absorbing tape 80 is let off from the let-off shaft 6, a portion of the ACF 86A having an area corresponding to the area of a lower face of the head member 98 within the ACF 86A of the ACF tape 86 is adhered to a predetermined position of the electric work 85 by the pressing force of the head member 98 via the shock-absorbing tape 80. Since this adhesion is performed via the shock-absorbing tape 80, the pressing force of the head member 98 operates evenly on the above-described portion of the ACF 86A. Therefore, the above-described portion of the ACF 86A is adhered evenly on the electric work 85.

Further, when the head member 98 moves down, the rod member 97A of the brake driving device 97 provided on the ACF adhering apparatus 90 moves down, and thereby the brake member 34 of the shock-absorbing tape supply device 1 which the rod member 97A abuts on pivots downward about the connecting bar 2 of FIG. 1. Accordingly, the brake member 34 contacts an upper side outer peripheral face of the flange part 6A being a portion of the outer peripheral face of the let-off shaft 6, and thus the braking means 35 constituted of the brake member 34 gives braking force to the let-off shaft 6 when letting off the shock-absorbing tape 80. Therefore, the let-off shaft 6 is prevented from being overly rotated by inertia from letting off the shock-absorbing tape 80.

When rotation of the let-off shaft 6 for letting off the shock-absorbing tape 80 is finished, the rod member 97A of the brake driving device 97 moves up to the original position.

Further, after the above-described portion of the ACF 86A is adhered evenly onto the electric work 85 by moving down of the head member 98, the head member 98 moves back to the original position, that is, it moves up. The above-described ACF supply device set to the ACF adhering apparatus 90 is driven to feed a predetermined amount of the ACF tape 86, and by feeding this predetermined amount, a portion different from the above-described portion of the ACF 86A adhered to the electric work 85 of the ACF tape 86 is supplied to the position where the head member 98 moves up and down. Moreover, by feeding the predetermined amount of the ACF tape 86, the above-described portion of the ACF 86A adhered to the electric work 85 peels off from the above-described separate film 86B of the ACF tape 86, and this film 86B is taken up on the take-up shaft of the ACF supply device.

By the head member 98 moving down and moving up as described above, slackness occurs on the shock-absorbing tape 80 corresponding to the length of the shock-absorbing tape 80 that is let off from the let-off shaft 6.

When the head member 98 returns to the original up position, the transmission gear 95 of the ACF adhering apparatus 90 rotates by a predetermined amount, thereby causing the drive gear 20 and the drive shaft 16 of the shock-absorbing tape supply device 1 to rotate by a predetermined amount in the C direction of FIG. 1. The rotation of the drive shaft 16 is transmitted to the take-up shaft 7 via the above-described connecting means 24, and the take-up shaft 7 rotates by a predetermined amount in the A direction of FIG. 1. Accordingly, the shock-absorbing tape 80 is taken up on the take-up shaft 7. Further, when the drive gear 20 and the drive shaft 16 rotate by a predetermined amount in the C direction of FIG 1, the rotation of the drive shaft 16 is transmitted to the let-off shaft 6 via the first and second plate-shaped friction members 31, 33 disposed between the let-off shaft 6 and the drive shaft 16. At this time, since the shock-absorbing tape 80 has slackness and the shock-absorbing tape 80 is not in a tense state, the let-off shaft 6 rotates by a predetermined amount by friction force of the friction members 31, 33 in the C direction of FIG. 1, which is the opposite direction to the direction B of FIG. 1 and is a direction to take up the shock-absorbing tape 80.

Accordingly, the shock-absorbing tape 80 having slackness is taken up by both the take-up shaft 7 and the let-off shaft 6, thereby eliminating the slackness of the shock-absorbing tape 80.

After the slackness of the shock-absorbing tape 80 is thus eliminated, the transmission gear 95 of the ACF adhering apparatus 90 rotates again by a predetermined amount. This rotation of the predetermined amount is transmitted to the drive gear 20 and the drive shaft 16 as rotation in the C direction of FIG. 1, and is transmitted further to the take-up shaft 7 via the connecting means 24 as rotation in the A direction of FIG. 1, and thereby a predetermined length of the shock-absorbing tape 80 is taken up by the take-up shaft 7. When this taking up of the shock-absorbing tape 80 by the take-up shaft 7 takes place, tensile force due to taking up by the take-up shaft 7 operates on the shock-absorbing tape 80, and hence this shock-absorbing tape 80 causes the let-off shaft 6 to rotate by a predetermined amount in the B direction of FIG. 1, which is a direction to let off the shock-absorbing tape 80. When the let-off shaft 6 thus rotates by a predetermined amount in the direction to let off the shock-absorbing tape 80, and the rotational direction of the let-off shaft 6 for letting off and the rotational direction of the drive shaft 16 for taking up the shock-absorbing tape 80 on the take-up shaft 7 are opposite, the slip by the first and second plate-shaped friction members 31, 33 occurs between the drive shaft 16 and the let-off shaft 6, thereby allowing the let-off shaft 6 to rotate by a predetermined amount in the direction to let off the shock-absorbing tape 80 toward the drive shaft 16.

By thus letting off a predetermined length of the shock-absorbing tape 80 from the let-off shaft 6, a new portion of the shock-absorbing tape 80 is supplied to the position where the head member 98 moves up and down.

Further, when the predetermined length of the shock-absorbing tape 80 is let off from the let-off shaft 6 as described above by rotation of the transmission gear 95 of the ACF adhering apparatus 90, the rod member 97A of the brake driving device 97 of the ACF adhering apparatus 90 moves down again, and thereby the brake member 34 of the shock-absorbing tape supply device 1 pivots downward about the connecting bar 2 of FIG. 1. Therefore, also at this time, the braking means 35 constituted of the brake member 34 gives braking force to the let-off shaft 6 when letting off the shock-absorbing tape 80, thereby preventing the let-off shaft 6 from being overly rotated by inertia. When rotation of the let-off shaft 6 for letting off the shock-absorbing tape 80 is then finished, the rod member 97A moves up again to the original position.

After the slackness of the shock-absorbing tape 80 is eliminated as described above and the predetermined length of the shock-absorbing tape 80 is let off from the let-off shaft 6, or when the slackness of the shock-absorbing tape 80 is being eliminated or the predetermined length of the shock-absorbing tape 80 is being let off from the let-off shaft 6, the slide table 87 moves so that the ACF 86A can be adhered to a portion different from the above-described portion of the electric work 85 of FIG. 6 to which the above-described portion of the ACF 86A is adhered, or that the ACF 86A can be adhered to an electric work 85 different from the electric work 85 of FIG. 6.

By one time of up and down movement of the head member 98 as described above, and feeding the predetermined amount of the ACF tape 86 accompanying this one time of up and down movement or letting off the predetermined length of the shock-absorbing tape 80, one time of operation to adhere the ACF 86A to a predetermined position of the electric work 85 of FIG. 6 is finished. Then up and down movement of the head member 98, feeding the predetermined amount of the ACF tape 86, letting off the predetermined length of the shock-absorbing tape 80, and further slide movement of the slide table 87 are repeated to thereby repeat the operation to adhere the ACF 86A to a portion different from the above-described portion of the electric work 85 of FIG. 6 or to an electric work 85 different from the electric work 85 of FIG. 6.

In the embodiment described above, a swingable swing member is not used for eliminating slackness occurred on the shock-absorbing tape 80 by up and down movement of the head member 98, and thus it is not necessary to secure a space for the swing member to swing in the device 1 according to this embodiment. Therefore, reduction in size of the device 1 can be achieved.

According to this embodiment, as a drive source for eliminating slackness of the shock-absorbing tape 80, only the drive source for rotating the drive shaft 16 will suffice. Thus, simplification of the structure of the device 1 can be achieved.

Further according to this embodiment, slackness occurred on the shock-absorbing tape 80 is eliminated by taking up the shock-absorbing tape 80 by both the take-up shaft 7 to which rotation of the drive shaft 16 is transmitted via the connecting means 24 and the let-off shaft 6 to which rotation of the drive shaft 16 is transmitted via the friction members 31, 33, and moreover, the take-up shaft 7 and the let-off shaft 6 are rotated simultaneously by rotation of the drive shaft 16. Thus, elimination of slackness of the shock-absorbing tape 80 is carried out quickly and hence in a short time. Accordingly, the number of times of operations performed by one time of up and down movement of the head member 98 can be increased within a certain time, and thus operation efficiency can be improved.

For disposing the friction members 31, 33 between the let-off shaft 6 and the drive shaft 16, the let-off shaft 6 is made as a hollow member, and the drive shaft 16 is inserted in this hollow let-off shaft 6, thereby using the inside space of the let-off shaft 6 as a space for disposing the drive shaft 16. Thus, further reduction in size of the device 1 can be achieved.

The arranging positions of the friction members 31, 33 between the let-off shaft 6 and the drive shaft 16 are positions in the axial direction of the drive shaft 16, and the friction members 31, 33 are in a plate shape whose thickness direction is in the axial direction of the drive shaft 16. Therefore, the dimension of the device 1 in the axial direction of the drive shaft 16 does not become large.

Since the two friction members 31, 33 are provided separately in the axial direction of the drive shaft 16, rotation of the drive shaft 16 for eliminating slackness of the shock-absorbing tape 80 can be transmitted securely to the let-off shaft 6 by friction force of these friction members 31, 33.

Further, since the device 1 is provided with the braking means 35 for giving braking force to the let-off shaft 6 when the let-off shaft 6 lets off the shock-absorbing tape 80, it is possible to prevent the let-off shaft 6 from rotating excessively by inertia or the shock-absorbing tape 80 from being let off excessively from the let-off shaft 6 due to such excessive rotation.

Also the braking means 35 has the brake member 34 contacting the outer peripheral face of the let-off shaft 6, and the portion of the let-off shaft 6 where this brake member 34 contacts is the outer peripheral face of the flange part 6A of the let-off shaft 6 that is larger in diameter than the body of the let-off shaft 6. Thus, sufficiently large brake torque can be secured for preventing the let-off shaft 6 from rotating excessively, without increasing the load to be pushed to the outer peripheral face of the flange part 6A of the brake member 34 by the rod member 97A of the brake driving device 97. Accordingly, reduction in size of the brake driving device 97 can be achieved.

Furthermore, the brake member 34 is a member which pivots about the connecting bar 2, and thus simplifying the shape and structure of the brake member 34 itself allows to produce the braking means 35 easily.

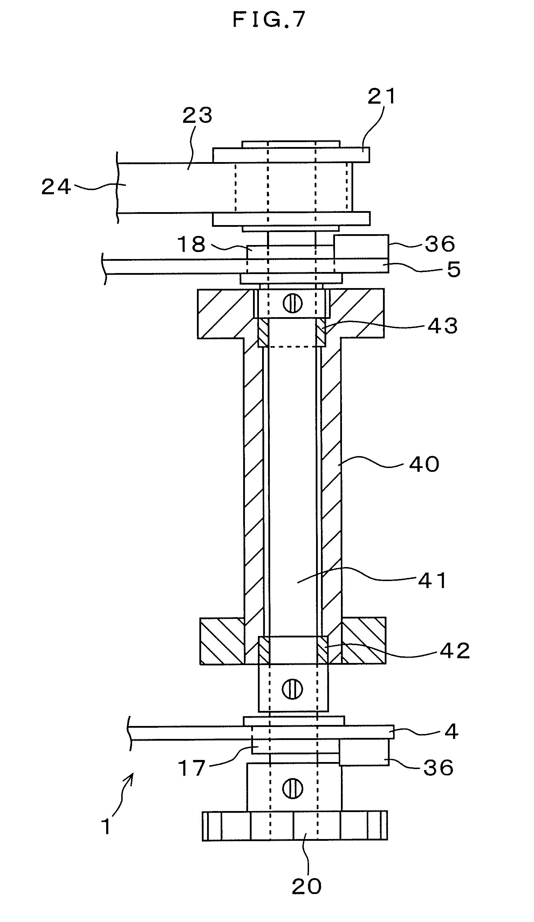

FIG. 7 shows another embodiment with respect to friction members disposed between a drive shaft and a take-up shaft. Also in this embodiment a drive shaft 41, having one end portion to which the drive gear 20 is attached and the other end portion to which the timing pulley 21 of the connecting means 24 is attached, is inserted in a let-off shaft 40 which is a hollow member. On an outer periphery of the drive shaft 41, first and second cylindrical friction members 42, 43 are engaged inside the let-off shaft 40. Accordingly, also in this embodiment, the two friction members 42, 43 are disposed between the let-off shaft 40 and the drive shaft 41, and these cylindrical friction members 42, 43 function similarly to the plate-shaped friction members 31, 33 in the above-described embodiment when eliminating slackness of the shock-absorbing tape 80, or the like.

According to this embodiment, the arranging positions of the friction members 42, 43 between the let-off shaft 40 and the drive shaft 41 are positions in a diametrical direction of the drive shaft 41, and thus the dimension of the shock-absorbing tape supply device 1 in an axial direction of the drive shaft 41 can be reduced more than when using the plate-shaped friction members 31, 33.

The shock-absorbing tape supply devices 1 according to the embodiments described above are used when adhering the ACF 86A to the electric work 85. However, also when pressure bonding an electric part to an electric work via the ACF, each of the shock-absorbing tape supply devices 1 according to the embodiments can be used.

### Industrial Availability

The present invention can be used when adhering an ACF to an electric work, or pressure bonding an electric part to the electric work via the ACF.

## Claims

1. A device for eliminating slackness of a shock-absorbing tape, the device comprising a shock-absorbing tape disposed between an electric work and a head member movable toward the electric work, so as to adhere an ACF to the electric work to which an electric part is pressure bonded via the ACF, or to pressure bond the electric part to the electric work via the ACF, and the device comprising a let-off shaft on which a source side portion of the shock-absorbing tape is wound, in which slackness is generated by the head member moving forward to the electric work while pushing the shock-absorbing tape and then moving backward, and a take-up shaft for taking up a target side portion of the shock-absorbing tape,
wherein the device comprises a drive shaft connected to the take-up shaft via a connecting means for rotating the take-up shaft in a direction to take up the shock-absorbing tape, and at least one friction member disposed between the drive shaft and the let-off shaft, and
wherein a rotational direction of the take-up shaft for the take-up shaft to take up the shock-absorbing tape and a rotational direction of the drive shaft for the take-up shaft to take up the shock-absorbing tape are the same, and a rotational direction for the let-off shaft to let off the shock-absorbing tape and the rotational direction for the take-up shaft to take up the shock-absorbing tape are opposite.

2. The device for eliminating slackness of the shock-absorbing tape according to claim 1,
wherein the drive shaft is inserted in an inside of the let-off shaft which is hollow.

3. The device for eliminating slackness of the shock-absorbing tape according to claim 2,
wherein both end portions of the drive shaft project from the let-off shaft, and a drive gear meshing with a transmission gear for rotating the drive shaft is fixed to one of the end portions, and the other one of the end portions is connected to the take-up shaft via the connecting means.

4. The device for eliminating slackness of the shock-absorbing tape according to claim 2,
wherein the friction member is in a plate shape whose thickness direction is in an axial direction of the drive shaft.

5. The device for eliminating slackness of the shock-absorbing tape according to claim 2,
wherein the friction member is in a cylindrical shape engaged with an outer periphery of the drive shaft.

6. The device for eliminating slackness of the shock-absorbing tape according to claim 1,
wherein there is a plurality of the friction members, and these friction members are disposed in an axial direction of the drive shaft.

7. The device for eliminating slackness of the shock-absorbing tape according to claim 1, further comprising
a braking means for applying braking force to the let-off shaft when the let-off shaft lets off the shock-absorbing tape.

8. The device for eliminating slackness of the shock-absorbing tape according to claim 7,
wherein the braking means comprises a brake member contacting an outer peripheral face of the let-off shaft.

9. The device for eliminating slackness of the shock-absorbing tape according to claim 8,
wherein the outer peripheral face of the let-off shaft where the brake member contacts is an outer peripheral face of a flange part of the let-off shaft which is formed larger in diameter than a body of the let-off shaft.

10. The device for eliminating slackness of the shock-absorbing tape according to claim 8,
wherein the brake member is a member which pivots about a bar.
